# EUROPÄISCHE PATENTSCHRIFT

(11) **EP 3 333 281 B1**
(45) Veröffentlichungstag und Bekanntmachung des Hinweises auf die Patenterteilung: **03.03.2021**
(21) Anmeldenummer: 17204909.0
(22) Anmeldetag: 01.12.2017
(51) Int. Cl.: C23C 14/16, C23C 14/35, C23C 30/00, C22C 21/00, B32B 15/01, F01D 5/28, C22C 14/00, C22C 30/00

(54) **HOCHTEMPERATURSCHUTZSCHICHT FÜR TITANALUMINID - LEGIERUNGEN**
HIGH-TEMPERATURE PROTECTIVE LAYER FOR TITANIUM ALUMINIDE ALLOYS
COUCHE DE PROTECTION HAUTE TEMPÉRATURE POUR ALLIAGES À BASE D'ALUMINURES DE TITANE

(30) Priorität: 08.12.2016 DE 102016224532
(43) Veröffentlichungstag der Anmeldung: 13.06.2018
(73) Patentinhaber: MTU Aero Engines AG, 80995 München (DE)
(72) Erfinder: Schloffer, Martin, 81247 München (DE); Warnecke, Heiko, 29328 Faßberg (DE)

(56) Entgegenhaltungen:
- EP-A1- 0 581 204
- CN-A- 104 480 444
- DE-A1- 4 435 321
- DE-C1- 4 222 210

## Beschreibung

### HINTERGRUND DER ERFINDUNG

### GEBIET DER ERFINDUNG

Die vorliegende Erfindung betrifft ein Verfahren zur Herstellung einer Hochtemperaturschutzschicht und insbesondere einer Oxidationsschutzschicht für TiAl - Legierungen sowie ein Bauteil aus einer TiAl - Legierung mit einer entsprechenden Schutzschicht, insbesondere ein Bauteil für eine Strömungsmaschine, wie eine Gasturbine oder ein Flugtriebwerk.

### STAND DER TECHNIK

Titanaluminide und ihre Legierungen sind aufgrund der in diesen Werkstoffen enthaltenen intermetallischen Phasen, wie α₂ - Ti₃Al und γ - TiAl, die den Werkstoffen eine hohe Festigkeit bei gleichzeitig niedrigem spezifischen Gewicht verleihen, interessante Werkstoffe für unterschiedlichste Bauteile in der Luft - und Raumfahrt sowie im Motorenbau oder der chemischen Industrie. Allerdings ist ihr Einsatz bei Temperaturen im Bereich oberhalb von 700°C bis 750°C durch eine ungenügende Heißgas - und Hochtemperaturoxidationsbeständigkeit der TiAl - Werkstoffe begrenzt, obwohl durch den hohen Aluminium - Gehalt die Ausbildung einer langsam wachsenden und somit schützenden Aluminiumoxidschicht erwartet werden könnte. Entsprechend sind aus dem Stand der Technik Versuche bekannt, die Heißgaskorrossions - und Oxidationsbeständigkeit zu verbessern, um höhere Einsatztemperaturen zu ermöglichen.

Hierzu wird beispielsweise in der WO 03/071002 A1 vorgeschlagen, eine Aluminiumschicht auf der Oberfläche eines Bauteils aus einem TiAl - Werkstoff abzuscheiden und diese anschließend einer Wärmebehandlung zu unterziehen, sodass das Aluminium oxidiert und durch Diffusion in den darunter liegenden TiAl - Werkstoff in diesem angereichert wird. Zwar kann damit durch die Ausbildung einer dichten, langsam wachsenden Aluminiumoxidschicht an der Oberfläche ein Hochtemperaturoxidationsschutz erzielt werden, aber durch das Eindiffundieren von Aluminium in den Randbereich des TiAl - Werkstoffes des Bauteils kann es zu einer Beeinträchtigung der Festigkeit des Grundwerkstoffes kommen, beispielsweise indem spröde aluminiumreiche, intermetallische Phasen gebildet werden.

In der DE4435321A1 wird eine niobmodifizierte Beschichtung mit einem Nb-Anteil im Bereich von 8 - 21 at.% für ein TiAl-Grundmaterial vorgeschlagen.

In der europäischen Patentanmeldung EP 2 071 046 A2 wird ferner eine platinbasierte Hochtemperaturschutzschicht auf TiAl - Basis vorgeschlagen, während in dem US - Dokument US 5 837 387 A eine chromhaltige TiAl - Hochtemperaturschutzschicht vorgeschlagen wird. Bei beiden Beschichtungen auf Basis von TiAl - Legierungen besteht jedoch ebenfalls das Problem, dass es durch die hohen Anteile an Platin und Chrom zu Phasenumwandlungen im Randbereich des TiAl - Grundwerkstoffs des zu schützenden Bauteils kommen kann.

Entsprechend besteht weiterhin Bedarf an einer Hochtemperaturschutzschicht, die es ermöglicht, Bauteile auf Basis einer TiAl - Legierung für Einsatzbereiche über 700° Celsius mit einer Hochtemperaturschutzschicht zu versehen, die insbesondere eine schnelle Oxidation des TiAl - Grundwerkstoffs und das Eindiffundieren von Sauerstoff in den Randbereich des Grundwerkstoffes verhindert.

### OFFENBARUNG DER ERFINDUNG

### AUFGABE DER ERFINDUNG

Es ist deshalb Aufgabe der vorliegenden Erfindung, eine Hochtemperaturschutzschicht und insbesondere eine Oxidationsschutzschicht für Bauteile aus TiAl - Legierungen vorzuschlagen, die eine Erhöhung der Einsatztemperatur von TiAl - Werkstoffen ohne Beeinträchtigung der mechanischen Eigenschaften ermöglicht. Weiterhin soll die Beschichtung einfach herstellbar und zuverlässig in der Anwendung sein.

### TECHNISCHE LÖSUNG

Diese Aufgabe wird gelöst durch ein Verfahren mit den Merkmalen des Anspruchs 1 sowie ein Bauteil mit dem Merkmal des Anspruchs 10. Vorteilhafte Ausgestaltungen sind Gegenstand der abhängigen Ansprüche.

Die Erfindung schlägt vor, auf einem Bauteil aus einer TiAl - Legierung als Hochtemperaturschutzschicht eine Schutzschichtlegierung mit höherem Aluminiumgehalt als die Legierung des Grundwerkstoffes vorzusehen, wobei auf bestimmte Elemente, wie Platin oder Chrom oder auch Nickel verzichtet wird, um eine ungünstige Beeinflussung des Grundwerkstoffes mit entsprechenden Phasenumwandlungen zu vermeiden. Die Schutzschichtlegierung wird durch eine TiAl - Legierung gebildet, die 57 bis 65 at.% Aluminium, 3 bis 6 at. % Niob, 0,2 bis 2 at.% Molybdän und 0,05 bis 0,2 at.% Bor sowie Rest Titan aufweist, wobei weitere Legierungsbestandteile enthalten sein können, insbesondere Wolfram, Kohlenstoff, Zirkon, Yttrium, Hafnium, Erbium, Gadolinium, Silizium. Somit weist die Schutzschichtlegierung folgende Zusammensetzung auf:

| | |
|---|---|
| Al | 57 bis 65 at.%, |
| Nb | 3 bis 6 at. %, |
| Mo | 0,2 bis 2 at.% |
| B | 0,05 bis 0,2 at.% |
| W | 0 bis 3 at.% |
| Si | 0 bis 0,5 at.% |
| C | 0 bis 0,6 at. % |
| Zr | 0 bis 6 at.% |
| Y | 0 bis 0,5 at.% |
| Hf | 0 bis 0,3 at.% |
| Er | 0 bis 0,5 at.% |
| Gd | 0 bis 0,5 at.% |

sowie Rest Titan.

Durch den hohen Aluminiumanteil der TiAl - Legierung, die als Beschichtung aufgebracht wird, kann sichergestellt werden, dass sich eine langsam wachsende, schützende Aluminiumoxidschicht an der Oberfläche ausbildet.

Die Zugabe von Silizium, Erbium und / oder Gadolinium kann die Sauerstoffdiffusion in den Werkstoff hemmen, sodass die bei derzeitigen TiAl - Legierungen zu beobachtende Eindiffusion von Sauerstoff bei Temperaturen von über 700° Celsius verringert bzw. vermieden werden kann, sodass unabhängig und im Zusammenspiel mit den gegenüber Sauerstoffangriff unempfindlichen, aluminiumreichen Phasen die Gefügedestabilisierung durch Sauerstoffangriff in den Bauteilrandzonen verringert bzw. verhindert werden kann.

Darüber hinaus wird erfindungsgemäß vorgesehen die Beschichtung durch physikalische Dampfphasenabscheidung (PVD physical vapour deposition) bei einer Temperatur kleiner oder gleich 600° Celsius abzuscheiden, sodass auch durch die Temperaturbelastung während der Beschichtung keine ungünstige Veränderung des Grundwerkstoffes auftreten kann. Dadurch kann eine wirksame Hochtemperaturschutzschicht bei gleichzeitiger Erhaltung der mechanischen Eigenschaften des Bauteils beziehungsweise des Gefüges des Grundwerkstoffes erreicht werden.

Die Abscheidung der Beschichtung kann durch Kathodenzerstäubung und insbesondere durch Magnetronsputtern erfolgen. Das Target, welches durch Kathodenzerstäubung zerstäubt wird und durch die Schutzschichtlegierung gebildet wird, die auf dem Bauteil abgeschieden werden soll, kann pulvermetallurgisch hergestellt werden, wobei das Target ein feinkörniges Gefüge aufweisen kann. Durch ein feinkörniges Gefüge werden gleichmäßige Abscheideraten und eine homogene Elementverteilung der Legierung in der Beschichtung erreicht. Das Targetmaterial kann eine zu der Schutzschichtlegierung leicht unterschiedliche Zusammensetzung aufweisen, um möglicherweise bei der Beschichtung auftretende Verluste an Legierungskomponenten auszugleichen, sodass die abgeschiedene Beschichtung in ihrer Zusammensetzung der gewünschten Schutzschichtlegierung entspricht.

Die Schutzschichtlegierung kann auf dem TiAl - Bauteil mit einer Schichtdicke von 5 bis 100 µm, insbesondere 15 bis 50 µm abgeschieden werden, sodass zuverlässig eine Eindiffusion von Sauerstoff bis zum Grundwerkstoff verhindert werden kann.

Unter TiAl - Legierung wird im Folgenden eine Legierung verstanden, deren Hauptbestandteile Titan und Aluminium sind, sodass also der Anteil an Aluminium und Titan in at.% oder Gew.% jeweils größer ist als der entsprechende Anteil jeder anderen Legierungskomponente. Hierbei kann der Aluminium - Anteil in at.% oder Gew.% größer als der Titan - Anteil sein, auch wenn die Bezeichnung TiAl das Gegenteil anzudeuten scheint. Darüber hinaus wird unter einer TiAl - Legierung eine Legierung verstanden, die überwiegend aus intermetallischen Phasen mit den Bestandteilen Titan und/oder Aluminium aufgebaut ist. Unter intermetallischen Phasen sind Phasen des TiAl -Systems zu verstehen, die einen hohen Anteil kovalenter Bindungskräfte innerhalb der metallischen Bindung aufweisen und so über eine hohe Festigkeit und insbesondere auch Hochtemperaturfestigkeit verfügen.

Das Bauteil, auf dem die Beschichtung erfolgt und aus einer TiAl - Legierung mit gegenüber der Beschichtung geringerem Al - Anteil gebildet ist, kann aus einer TiAl - Legierung mit mindestens 30 at.% Titan und mindestens 30 at.% Aluminium gebildet sein. Die weiteren Legierungsbestandteile können über einen weiten Bereich variieren und sämtlich technisch einsetzbare TiAl - Legierungen umfassen.

Insbesondere kann die TiAl - Legierung des Bauteils bzw. Grundwerkstoffs eine TiAl - Legierung auf Basis der intermetallischen γ - TiAl - Phase sein, die mit Niob und Molybdän oder Bor legiert ist und deshalb als TNM bzw. TNB - Legierungen bezeichnet werden kann. Derartige Legierungen weisen als Hauptbestandteil Titan sowie ca. 40 bis 45 at.% Aluminium, um 5 at.% Niob und beispielsweise 1 at.% Molybdän sowie geringe Anteile an Bor auf. Das Gefüge ist durch einen hohen γ - TiAl - Anteil und ebenfalls deutliche Anteile an α₂ - Ti₃Al gekennzeichnet, wobei weitere Phasen, wie z.B. β - Phase oder B19 - Phase, in geringerem Anteil vorkommen können.

Nach der Abscheidung der Beschichtung kann eine Wärmebehandlung durchgeführt werden, um das Gefüge in der Hochtemperaturschutzschicht in der gewünschten Art und Weise einzustellen.

Bei einem Bauteil mit einer entsprechend abgeschiedenen Hochtemperaturschutzschicht aus einer aluminiumreicheren TiAl - Legierung als der TiAl - Legierung des Grundwerkstoffs kann unter Verzicht auf Bestandteile wie Platin oder Chrom erreicht werden, dass keine oder nur geringfügige Änderungen der Gefügeausbildung des Randbereichs des Grundwerkstoffs auftreten. Die aluminiumreiche TiAl - Legierung, die auf dem Bauteil aus einem TiAl - Werkstoff abgeschieden wird, kann eine Zusammensetzung aufweisen, durch die insbesondere erreicht wird, dass der Anteil der γ - TiAl - Phase größer oder gleich 75 vol.%, insbesondere größer oder gleich 90 vol.% des Gefüges der Hochtemperaturschutzschicht ist. Insbesondere kann mit der vorzugsweise verwendeten TiAl - Legierung, die oben beschrieben worden ist, eine Beschichtung abgeschieden werden, die eine Matrix aus γ - TiAl aufweist, die ein in sich geschlossenes globulares Gefüge besitzt. Der Anteil des γ - TiAl kann größer oder gleich 90 Vol.% des Gefüges ausmachen. In der γ - TiAl Matrix können unterschiedliche weitere Phasen, wie beispielsweise α - Phase oder aluminiumreiche intermetallische Phasen, wie Al₃Ti und Al₂Ti vorgesehen sein. Außerdem können Oxide und/oder Karbide und/oder Silizide ausgebildet werden. Insbesondere können Anteile an Zirkon und Yttrium im Beschichtungswerkstoff durch die der Beschichtung nachfolgende Wärmebehandlung zu Zirkonoxiden und Yttriumoxiden in der Beschichtung ausgebildet werden.

Die Beschichtung wird zur Vermeidung des Eindringens von Sauerstoff in den Grundwerkstoff des Bauteils möglichst dicht ausgebildet und kann eine Porosität aufweisen, die kleiner oder gleich 1 vol.%, insbesondere kleiner oder gleich 0,5 vol.% ist.

Durch die dichte Ausbildung der Beschichtung mit hohem Aluminiumgehalt kann ein Eindringen von Sauerstoff in den Grundwerkstoff verhindert werden und der Oxidationsangriff kann durch eine sich beim Hochtemperatureinsatz ausbildende, langsam wachsende Aluminiumoxidschicht begrenzt werden. Da zudem mit Ausnahme der angegebenen Legierungselemente auf weitere Legierungsbestandteile in der TiAl - Legierung für die Beschichtung verzichtet wird und/oder der Anteil der Legierungselemente beschränkt wird, kann vermieden werden, dass Gefügeumwandlungen in der Randzone des Grundwerkstoffs des zu beschichtenden Bauteils auftreten und die mechanischen Eigenschaften negativ beeinträchtigen.

### AUSFÜHRUNGSBEISPIEL

Auf einem Bauteil einer Strömungsmaschine aus einer TiAl - Legierung, wie sie oben beispielhaft angegeben worden ist, wird eine Beschichtung mit der Zusammensetzung 61 at.% Aluminium, 4 at.% Niob, 1 at.% Molybdän, 0,2 at.% Silizium, 0,3 at.% Kohlenstoff, 0,1 at.% Yttrium und 0,1 at.% Bor sowie Rest Ti durch Kathodenzerstäubung bei einer Temperatur kleiner 600° Celsius mit einer Dicke im Bereich von 15 bis 50 Mikrometer abgeschieden.

Bei einer Auslagerung bei 900° Celsius über 1000 Stunden bildet sich eine dichte, festhaftende Aluminiumoxiddeckschicht aus, sodass die Massenzunahme kleiner gleich 2 mg pro cm² ist. In dem Grenzbereich zwischen Hochtemperaturschutzschicht und Grundwerkstoff werden keine Phasenumwandlungen und/oder die Ausbildung von spröden Phasen beobachtet.

## Patentansprüche

1. Verfahren zur Beschichtung eines Bauteils aus einer TiAl - Legierung zur Verbesserung der Hochtemperaturbeständigkeit des Bauteils,
**dadurch gekennzeichnet, dass**
auf dem Bauteil eine Pt - und Cr - freie Schutzschichtlegierung mit
| | |
|---|---|
| Al | 57 bis 65 at.%, |
| Nb | 3 bis 6 at. %, |
| Mo | 0,2 bis 2 at.% |
| B | 0,05 bis 0,2 at.% |
| W | 0 bis 3 at.% |
| Si | 0 bis 0,5 at.% |
| C | 0 bis 0,6 at. % |
| Zr | 0 bis 6 at.% |
| Y | 0 bis 0,5 at.% |
| Hf | 0 bis 0,3 at.% |
| Er | 0 bis 0,5 at.% |
| Gd | 0 bis 0,5 at.% |
sowie Rest Titan durch physikalische Dampfphasenabscheidung bei einer Temperatur von kleiner oder gleich 600°C abgeschieden wird, wobei die Schutzschichtlegierung einen höheren Al - Gehalt als die TiAl - Legierung des Bauteils aufweist.

2. Verfahren nach Anspruch 1,
**dadurch gekennzeichnet, dass**
die physikalische Dampfphasenabscheidung durch Kathodenzerstäubung erfolgt, wobei insbesondere das Target für die Kathodenzerstäubung pulvermetallurgisch hergestellt wird.

3. Verfahren nach einem der vorhergehenden Ansprüche,
**dadurch gekennzeichnet, dass**
die TiAl - Legierung auf dem Bauteil mit einer Schichtdicke von 10 bis 100 µm, insbesondere 15 bis 50 µm abgeschieden wird.

4. Verfahren nach einem der vorhergehenden Ansprüche,
**dadurch gekennzeichnet, dass**
das Bauteil, auf dem die Beschichtung erfolgt, aus einer TiAl - Legierung mit mindestens 30 at.% Titan und mindestens 30 at.% Aluminium gebildet ist.

5. Verfahren nach einem der vorhergehenden Ansprüche,
**dadurch gekennzeichnet, dass**
nach der Abscheidung der Hochtemperaturschutzschicht eine Wärmebehandlung zur Einstellung des Gefüges der Hochtemperaturschutzschicht vorgenommen wird.

6. Bauteil, insbesondere für eine Strömungsmaschine, mit einem Grundwerkstoff aus einer TiAl - Legierung und mit einer zumindest teilweise an der Oberfläche des Bauteils angeordneten Oxidationsschutzbeschichtung aus einer Pt - und Cr - freie Schutzschichtlegierung mit
| | |
|---|---|
| Al | 57 bis 65 at.%, |
| Nb | 3 bis 6 at. %, |
| Mo | 0,2 bis 2 at.% |
| B | 0,05 bis 0,2 at.% |
| W | 0 bis 3 at.% |
| Si | 0 bis 0,5 at.% |
| C | 0 bis 0,6 at. % |
| Zr | 0 bis 6 at.% |
| Y | 0 bis 0,5 at.% |
| Hf | 0 bis 0,3 at.% |
| Er | 0 bis 0,5 at.% |
| Gd | 0 bis 0,5 at.% |
sowie Rest Titan, vorzugsweise abgeschieden mit einem Verfahren nach einem der vorhergehenden Ansprüche, welche einen höheren Al - Gehalt als die TiAl - Legierung des Bauteils aufweist.

7. Bauteil nach Anspruch 6,
**dadurch gekennzeichnet, dass**
der Anteil an γ - TiAl - Phase in der Beschichtung 75 vol.%. oder mehr, insbesondere 90 vol.% oder mehr des Gefüges beträgt.

8. Bauteil nach Anspruch 6 oder 7,
**dadurch gekennzeichnet, dass**
in der Beschichtung eine γ - TiAl - Matrix mit einem in sich geschlossenen oder netzartigen oder globularen Gefüge vorliegt.

9. Bauteil nach einem der Ansprüche 6 bis 8,
**dadurch gekennzeichnet, dass**
die Ausscheidungen in der Beschichtung ZrO₂ und/oder Y₂O₃ umfassen.

10. Bauteil nach einem der Ansprüche 6 bis 9,
**dadurch gekennzeichnet, dass**
die Beschichtung eine Porosität kleiner oder gleich 1 vol.%, insbesondere kleiner oder gleich 0,5 vol.% aufweist.

## Claims

1. A method for coating a component made of a TiAl alloy in order to improve the high - temperature resistance of the component, **characterized in that** a Pt- and Cr-free protective layer alloy comprising
| | |
|---|---|
| Al | 57 to 65 at.% |
| Nb | 3 to 6 at. % |
| Mo | 0.2 to 2 at.% |
| B | 0.05 to 0.2 at. % |
| W | 0 to 3 at. % |
| Si | 0 to 0.5 at.% |
| C | 0 to 0.6 at.% |
| Zr | 0 to 6 at. % |
| Y | 0 to 0.5 at.% |
| Hf | 0 to 0.3 at.% |
| Er | 0 to 0.5 at.% |
| Gd | 0 to 0.5 at.% |
and the remainder titanium is deposited on the component by means of physical vapor deposition at a temperature of less than or equal to 600°C, the protective layer alloy having a higher Al content than the TiAl alloy of the component.

2. The method according to claim 1, **characterized in that** the physical vapor deposition is performed by cathode sputtering, the target for the cathode sputtering being produced in particular by powder metallurgy.

3. The method according to any of the preceding claims, **characterized in that** the TiAl alloy is deposited on the component with a layer thickness of 10 to 100 µm, particularly 15 to 50 µm,

4. The method according to any of the preceding claims, **characterized in that** the component on which the coating takes place is formed from a TiAl alloy comprising at least 30 at. % titanium and at least 30 at.% aluminum.

5. The method according to any of the preceding claims, **characterized in that,** after the deposition of the high-temperature protective layer, a heat treatment is performed in order to adjust the structure of the high-temperature protective layer.

6. A component, particularly for a turbomachine, comprising a base material made of a TiAl alloy and an anti-oxidation coating, which is arranged at least partially on the surface of the component, made of a Pt- and Cr-free protective layer alloy comprising
| | |
|---|---|
| Al | 57 to 65 at.% |
| Nb | 3 to 6 at. % |
| Mo | 0.2 to 2 at.% |
| B | 0.05 to 0.2 at. % |
| W | 0 to 3 at. % |
| Si | 0 to 0.5 at.% |
| C | 0 to 0.6 at.% |
| Zr | 0 to 6 at. % |
| Y | 0 to 0.5 at.% |
| Hf | 0 to 0.3 at.% |
| Er | 0 to 0.5 at.% |
| Gd | 0 to 0.5 at.% |
and the remainder titanium, preferably deposited using a method according to any of the preceding claims, which protective layer alloy has a higher Al content than the TiAl alloy of the component.

7. The component according to claim 6, **characterized in that** the proportion of γ-TiAl phase in the coating constitutes 75 vol.% or more, particularly 90 vol.% or more of the structure.

8. The component according to claim 6 or 7, **characterized in that** a γ-TiAl matrix with a self-contained or network-like or globular structure is present in the coating.

9. The component according to any of claims 6 to 8, **characterized in that** the precipitates in the coating comprise ZrO₂ and/or Y₂O₃.

10. The component according to any of claims 6 to 9, **characterized in that** the coating has a porosity of less than or equal to 1 vol.%, particularly less than or equal to 0.5 vol.%.

## Revendications

1. Procédé de revêtement d'un composant constitué d'un alliage TiAl permettant d'améliorer la résistance à haute température du composant,
**caractérisé en ce que**
sur le composant, un alliage de couche de protection sans Pt et Cr comportant
| | |
|---|---|
| Al | 57 à 65 pour cent d'atome, |
| Nb | 3 à 6 pour cent d'atome, |
| Mo | 0,2 à 2 pour cent d'atome |
| B | 0,05 à 0,2 pour cent d'atome |
| W | 0 à 3 pour cent d'atome |
| Si | 0 à 0,5 pour cent d'atome |
| C | 0 à 0,6 pour cent d'atome |
| Zr | 0 à 6 pour cent d'atome |
| Y | 0 à 0,5 pour cent d'atome |
| Hf | 0 à 0,3 pour cent d'atome |
| Er | 0 à 0,5 pour cent d'atome |
| Gd | 0 à 0,5 pour cent d'atome |
ainsi qu'un reste de titane est déposé pardépôt physique en phase vapeur à une température inférieure ou égale à 600 °C, l'alliage de couche de protection présentant une teneur en Al plus élevée que l'alliage TiAl du composant.

2. Procédé selon la revendication 1,
**caractérisé en ce que**
le dépôt physique en phase vapeur a lieu par pulvérisation cathodique, la cible de pulvérisation cathodique étant en particulier réalisée par métallurgie des poudres.

3. Procédé selon l'une des revendications précédentes,
**caractérisé en ce que**
l'alliage TiAl est déposé sur le composant avec une épaisseur de couche de 10 à 100 µm, en particulier de 15 à 50 µm.

4. Procédé selon l'une des revendications précédentes,
**caractérisé en ce que**
le composant sur lequel le revêtement a lieu est formé d'un alliage TiAl comportant au moins 30 pour cent d'atome de titane et au moins 30 pour cent d'atome d'aluminium.

5. Procédé selon l'une des revendications précédentes,
**caractérisé en ce que**
après le dépôt de la couche de protection haute température, un traitement thermique est effectué pour ajuster la structure de la couche de protection haute température.

6. Composant, en particulier destiné à une turbomachine, comportant un matériau de base constitué d'un alliage TiAl et un revêtement anti-oxydation disposé au moins partiellement sur la surface du composant et constitué d'un alliage de couche de protection sans Pt et Cr comportant
| | |
|---|---|
| Al | 57 à 65 pour cent d'atome, |
| Nb | 3 à 6 pour cent d'atome, |
| Mo | 0,2 à 2 pour cent d'atome |
| B | 0,05 à 0,2 pour cent d'atome |
| W | 0 à 3 pour cent d'atome |
| Si | 0 à 0,5 pour cent d'atome |
| C | 0 à 0,6 pour cent d'atome |
| Zr | 0 à 6 pour cent d'atome |
| Y | 0 à 0,5 pour cent d'atome |
| Hf | 0 à 0,3 pour cent d'atome |
| Er | 0 à 0,5 pour cent d'atome |
| Gd | 0 à 0,5 pour cent d'atome |
et le reste de titane, déposé de préférence selon un procédé selon l'une des revendications précédentes, l'alliage de couche de protection présentant une teneur en Al plus élevée que l'alliage TiAl du composant.

7. Composant selon la revendication 6,
**caractérisé en ce que**
la proportion de phase γ-TiAl dans le revêtement représente 75 % en volume ou plus, en particulier 90 % en volume ou plus de la structure.

8. Composant selon la revendication 6 ou 7,
**caractérisé en ce que**
une matrice γ-TiAl comportant une structure autonome ou en réseau ou globulaire est présente dans le revêtement.

9. Composant selon l'une des revendications 6 à 8,
**caractérisé en ce que**
les dépôts dans le revêtement comprennent du ZrO₂ et/ou du Y₂O₃.

10. Composant selon l'une des revendications 6 à 9,
**caractérisé en ce que**
le revêtement présente une porosité inférieure ou égale à 1 % en volume, en particulier inférieure ou égale à 0,5 % en volume.
